# EUROPÄISCHE PATENTSCHRIFT

(11) **EP 2 625 539 B1**
(45) Veröffentlichungstag und Bekanntmachung des Hinweises auf die Patenterteilung: **13.06.2018**
(21) Anmeldenummer: 11761533.6
(22) Anmeldetag: 01.09.2011
(51) Int. Cl.: G01R 31/327, H01H 47/00, B60L 3/00, B60L 3/04, H01H 47/02, H01H 71/04

(54) **VERFAHREN ZUR VORHERSAGE DER EINSATZFÄHIGKEIT EINES RELAIS ODER EINES SCHÜTZES**
METHOD FOR PREDICTING THE USABILITY OF A RELAY OR A CONTACTOR
PROCÉDÉ DE PRÉDICTION DE LA DISPONIBILITÉ OPÉRATIONNELLE D'UN RELAIS OU D'UNE PROTECTION

(30) Priorität: 05.10.2010 DE 102010041998
(43) Veröffentlichungstag der Anmeldung: 14.08.2013
(73) Patentinhaber: Robert Bosch GmbH, 70442 Stuttgart (DE); Samsung SDI Co., Ltd., Yongin-si, Gyeonggi-do 446-577 (KR)
(72) Erfinder: STECK, Armin, 72127 Kusterdingen (DE); PISCOL, Ralf, 71083 Herrenberg (DE)
(74) Vertreter: Bee, Joachim
(86) Internationale Anmeldenummer: PCT/EP2011/065097
(87) Internationale Veröffentlichungsnummer: WO 2012/045532

(56) Entgegenhaltungen:
- EP-A1- 2 166 365
- EP-A2- 1 335 484
- DE-B3-102004 054 374
- DE-U1- 20 310 043
- US-A- 3 633 098
- US-A- 6 089 310
- US-A1- 2009 212 975

## Beschreibung

Die vorliegende Erfindung betrifft ein Verfahren zur Vorhersage der Einsatzfähigkeit eines Relais oder eines Schützes sowie eine Beobachtungseinheit, welche dazu ausgelegt ist, das erfindungsgemäße Verfahren auszuführen.

### Stand der Technik

Es zeichnet sich ab, dass in Zukunft sowohl bei stationären Anwendungen (beispielsweise bei Windkraftanlagen) als auch in Fahrzeugen (beispielsweise in Hybrid- und Elektrofahrzeugen) vermehrt neue Batteriesysteme zum Einsatz kommen werden, an die sehr hohe Anforderungen bezüglich Zuverlässigkeit gestellt werden. Hintergrund für diese hohen Anforderungen ist, dass ein Ausfall der Batterie zu einem Ausfall des Gesamtsystems (beispielsweise ein Ausfall der Traktionsbatterie bei einem Elektrofahrzeug) oder sogar zu einem sicherheitsrelevanten Problem führen kann (bei Windkraftanlagen werden beispielsweise Batterien eingesetzt, um bei starkem Wind die Anlage durch eine Rotorblattverstellung vor unzulässigen Betriebszuständen zu schützen).

Um eine Trennung des Batteriesystems von den angeschlossenen Verbrauchern, beispielsweise von einem Fahrzeugbordnetz, zu ermöglichen, werden in der Regel Relais (beziehungsweise Schütze) in Reihe zu beiden Batteriepolen vorgesehen. Diese Relais müssen das mehrmalige Abschalten eines solchen Systems unter Last ermöglichen. Um diesen hohen Anforderungen gerecht zu werden, muss die Funktionalität dieser Relais sowohl diagnostiziert als auch vorhergesagt werden können.

In den Relais und den Schützen dient ein schaltbarer Elektromagnet als Antrieb für die Betätigung von Kontakten zum Ein-, Aus- und Umschalten einer elektrischen Last. Hierbei unterliegen die Kontakte beim Schalten von elektrischen Lasten grundsätzlich einem unterschiedlich großen Verschleiß, welcher bei Lasten mit mittleren bis hohen Leistungen erheblich zunimmt. Dabei kann es auch dazu kommen, dass die Kontakte miteinander verschweißen und dadurch verkleben, was zu erheblichen Gefahrensituationen führen kann. Deshalb ist es notwendig, den Zustand der Schaltkontakte zu überwachen und entsprechende zusätzliche Abschaltmaßnahmen der elektrischen Last einzuleiten.

In der DE 20310043 U1 wird eine Überwachungsvorrichtung beschrieben, in welcher dem zu überwachenden Relais ein Kontrollelement für die Spule des Relais zugeordnet ist. Die Kontrolleinrichtung liefert hierbei eine Information, ob die Spule angesteuert ist oder nicht. Dieses wird dadurch ermöglicht, dass das Kontrollelement ein magnetfeldempfindliches Bauteil umfasst und derart in der Nähe der Spule angeordnet ist, dass es bei eingeschalteter Spule von dessen erzeugtem Magnetfeld durchflossen wird, wodurch das Magnetfeld der Spule das Kontrollelement aktiviert. Hierbei ist ein Reed-Kontakt als Kontrollelement vorgesehen. Nachteilhaft an einer solchen Anordnung ist, dass notwendigerweise ein zusätzliches Bauteil am zu überwachenden Relais vorgesehen sein muss.

EP1335484A2, US6089310A, EP2166365A1, US2009/212975A1, DE102004054374B3 sowie US3633098A offenbaren ein Verfahren zur Prüfung von Relais, bei dem Strom und/oder Spannung und/oder Temperatur wiederholt gemessen werden und die Messwerte an eine Einheit übermittelt werden.

### Offenbarung der Erfindung

Die Erfindung betrifft ein Verfahren gemäß dem Anspruch 1.

Das erfindungsgemäße Verfahren zur Vorhersage der Einsatzfähigkeit eines Relais oder eines Schützes umfasst grundsätzlich folgende Schritte: Ein durch das Relais oder das Schütz fließender Strom wird wiederholt gemessen, und die Messwerte werden an eine Beobachtungseinheit übermittelt. Dabei erfolgt die Messung des durch das Relais oder das Schütz (19) fließenden Stroms während eines Schaltvorgangs des Relais oder des Schützes (19). Auf Grundlage der Messwerte und eines Temperaturmodells, welches einen Stromimpuls und den damit verbundenen Temperaturanstieg des Relais oder des Schützes (19) in Beziehung setzt, wird ein Temperaturanstieg des Relais oder des Schützes (19) berechnet oder abschätzt. Anhand dessen macht die Beobachtungseinheit eine Vorhersage über die Einsatzfähigkeit des Relais oder des Schützes.

Analog kann das Verfahren auch dadurch ausgeführt werden, dass eine an dem Relais oder dem Schütz anliegende Spannung gemessen wird, da diese Rückschlüsse auf den durch das Relais oder das Schütz fließenden Strom zulässt und umgekehrt. Grundsätzlich ist dies möglich, wenn der (Ersatz-)Widerstand des Relais oder des Schützes in den verschiedenen Phasen (während des Schließens und während eines geschlossenen Zustands) bekannt ist. Somit können entweder Strommesswerte oder Spannungsmesswerte durch die Beobachtungseinheit ausgewertet werden, wobei die Beobachtungseinheit daraus typischerweise die am Relais oder am Schütz wirkenden Leistungen berechnet. Auch können Messwerte beider physikalischen Größen gleichzeitig durch die Beobachtungseinheit ausgewertet werden, was aufgrund der damit verbundenen Redundanz vorteilhaft sein kann.

Das von der Beobachtungseinheit verwendete Modell kann auf Kennlinien beruhen, welche beispielsweise die elektrischen Leistungen, die geschaltet werden, oder die Lichtbögen, die durch die anliegenden Potentialunterschiede entstehen, mit Veränderungen am Relais oder am Schütz in Beziehung setzen.

Das erfindungsgemäße Verfahren kann insbesondere zur Berechnung einer Alterung oder zur Vorhersage eines Klebens des Relais oder des Schützes verwendet werden.

Bevorzugt ist, dass die Beobachtungseinheit auf Grundlage der Messwerte und des Modells eine aktuelle Temperatur des Relais oder des Schützes abschätzt. Dadurch, dass die aktuelle Temperatur des Relais oder des Schützes in der Beobachtungseinheit berechnet wird, entfällt die Notwendigkeit, die Temperatur durch eine an dem Relais oder dem Schütz angeordnete Temperaturerfassungvorrichtung zu messen. Vielmehr kommt die Erfindung grundsätzlich ohne den Einsatz von Temperaturerfassungsvorrichtungen aus. Allerdings kann die Abschätzung der aktuellen Temperatur des Relais oder des Schützes dadurch verbessert werden, dass eine Umgebungstemperatur des Relais oder des Schützes gemessen und der Umgebungstemperaturmesswert an die Beobachtungseinheit übermittelt wird. Es reicht hierbei jedoch aus, eine Temperaturerfassungvorrichtung vorzusehen, welche außerhalb des Relais oder des Schützes und nicht einmal in seiner Nähe angeordnet ist. Beispielsweise kann bei Anwendung des Verfahrens in einer Batterie die ohnehin von einer Batteriemanagementeinheit erfasste Batterietemperatur an die Beobachtungseinheit übermittelt werden.

Der durch das Relais oder das Schütz fließende Strom oder die an dem Relais oder dem Schütz anliegende Spannung kann in verschiedenen Phasen gemessen werden. So kann während eines Schaltvorgangs des Relais oder des Schützes, in welchem das Relais oder das Schütz von einem geöffneten in einen geschlossenen Zustand (oder umgekehrt) wechselt, gemessen werden. Bevorzugt können ferner auch zusätzliche Messungen während des geschlossenen Zustandes durchgeführt werden.

Wenn die geschätzte Temperatur des Relais oder des Schützes einen Temperaturschwellenwert übersteigt, kann ein Warnsignal erzeugt werden. Hierdurch oder durch ähnliche Maßnahmen kann ein Kleben des Relais oder des Schützes vermieden werden, was einen Sicherheits- und Zuverlässigkeitsgewinn darstellt.

Ein weiterer Aspekt der Erfindung betrifft eine Beobachtungseinheit gemäß dem beigefügten Anspruch 7, welche dazu ausgelegt ist, das erfindungsgemäße Verfahren auszuführen, eine Batterie, bevorzugt eine Lithium-Ionen-Batterie, mit der erfindungsgemäßen Beobachtungseinheit sowie ein Kraftfahrzeug mit der erfindungsgemäßen Batterie.

Neben ihrer Anwendung in einem Batteriesystem eines Kraftfahrzeugs kann die Erfindung auch vorteilhaft in anderen Systemen, beispielsweise Motor-Stopp-Start-Systemen verwendet werden, um die Lebensdauern von Relais oder Schützen vorherzusagen. In Motor-Stopp-Start-Systemen ist ein Relais für die Starteransteuerung vorgesehen, welches vor einen Starter-Motor geschaltet ist. Auch hier fließen während eines Einschaltvorgangs hohe Ströme, welche die Kontakte des Relais schädigen können.

### Zeichnungen

Ausführungsbeispiele der Erfindung werden anhand der Zeichnungen und der nachfolgenden Beschreibung näher erläutert. Es zeigen:
- Figur 1: ein Ausführungsbeispiel der erfindungsgemäßen Batterie und
- Figur 2: ein Ausführungsbeispiel des erfindungsgemäßen Verfahrens.

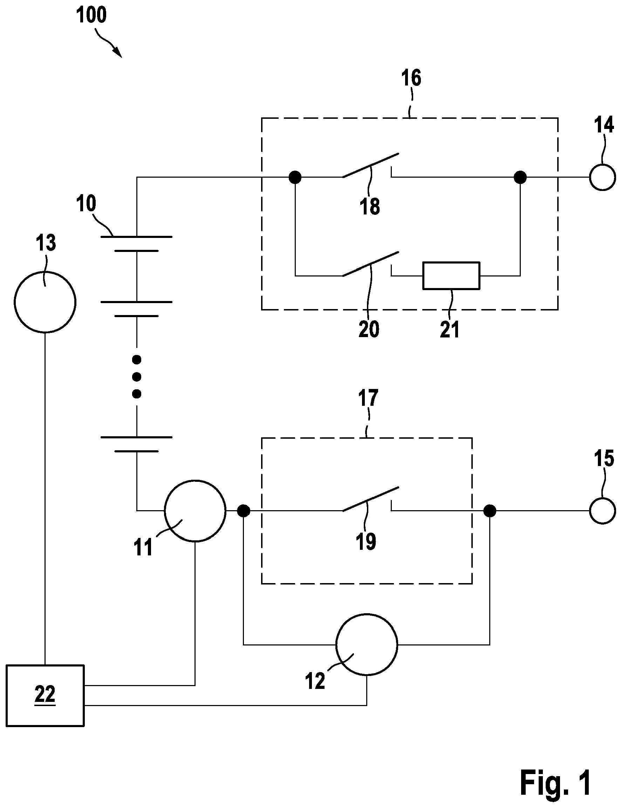

Figur 1 zeigt eine insgesamt mit 100 bezeichnete Batterie in einem Blockschaltbild. Eine Vielzahl von Batteriezellen 10 sind in Serie sowie optional zusätzlich parallel geschaltet, um eine für eine jeweilige Anwendung gewünschte hohe Ausgangsspannung und Batteriekapazität zu erreichen. Zwischen den Pluspol der Batteriezellen und ein positives Batterieterminal 14 ist eine Lade- und Trenneinrichtung 16 geschaltet. Zusätzlich ist zwischen den Minuspol der Batteriezellen 10 und ein negatives Batterieterminal 15 eine Trenneinrichtung 17 geschaltet. Die Trenn- und Ladeeinrichtung 16 und die Trenneinrichtung 17 umfassen jeweils ein Schütz 18 beziehungsweise 19, welche dafür vorgesehen sind, die Batteriezellen von den Batterieterminals 14, 15 abzutrennen, um die Batterieterminals spannungsfrei zu schalten. Aufgrund der hohen Gleichspannung der seriengeschalteten Batteriezellen 10 ist andernfalls erhebliches Gefährdungspotential für Wartungspersonal oder dergleichen gegeben. In der Lade- und Trenneinrichtung 16 ist zusätzlich ein Ladeschütz 20 mit einem zu dem Ladeschütz 20 in Serie geschalteten Ladewiderstand 21 vorgesehen. Der Ladewiderstand 21 begrenzt einen Aufladestrom, wenn die Batterie an einen nicht dargestellten Gleichspannungszwischenkreis angeschlossen wird. Hierzu wird zunächst das Schütz 18 offen gelassen und nur das Ladeschütz 20 geschlossen. Erreicht die Spannung am positiven Batterieterminal 14 die Spannung der Batteriezellen 10, kann das Schütz 19 geschlossen und gegebenenfalls das Ladeschütz 20 geöffnet werden. Die Schütze 18, 19 und das Ladeschütz 20 erhöhen die Kosten für eine Batterie 100 nicht unerheblich, da hohe Anforderungen an ihre Zuverlässigkeit und an die von ihnen zu führenden Ströme gestellt werden.

Jeder Aufschalt- und Zuschaltprozess an den Schützen 18, 19, 20 lässt diese altern. Es ist daher erforderlich, deren Lebensdauer zu schätzen, um Ausfällen vorbeugen zu können, sowie eine Diagnose zu stellen, wann eines der Schützen 18, 19, 20 ausgetauscht werden muss. Dazu wird das erfindungsgemäße Verfahren ausgeführt, welches auf jedes der Schütze 18, 19, 20 anwendbar ist, hier jedoch nur im Hinblick auf das (negative) Schütz 19 erläutert wird.

Die Batterie 100 beziehungsweise eine nicht genauer dargestellte Batteriemanagementeinheit umfasst eine Strommesseinheit 11, welche dazu ausgelegt ist, einen Batteriestrom und somit auch einen durch das Schütz 19 fließenden Strom zu messen, eine Spannungsvorrichtung 12, welche dazu ausgelegt ist, eine an dem Schütz 19 anliegende Spannung zu messen, sowie eine Temperaturmessvorrichtung 13, welche dazu ausgelegt ist, eine Batterietemperatur zu messen. Zur Ausführung des erfindungsgemäßen Verfahrens sind Messungen entweder durch die Strommessvorrichtung 11 oder durch die Spannungsvorrichtung 12 ausreichend, so dass die jeweils andere Messvorrichtung sowie die Temperaturmesseinrichtung 13 lediglich redundante Informationen liefern, beziehungsweise Informationen, welche die Berechnungen verfeinern.

Die Strommessvorrichtung 11, die Spannungsvorrichtung 12 und die Temperaturmessvorrichtung 13 übermitteln ihre Messwerte an ein Steuergerät 22, welches als Beobachtungseinheit dient, welche das erfindungsgemäße Verfahren ausführt, oder eine solche umfasst.

In Figur 1 ist somit die Beobachtungseinheit als Teil der Batterie 100, insbesondere einer Batteriemanagementeinheit, vorgesehen. Die Beobachtungseinheit kann jedoch auch außerhalb der Batterie 100 angeordnet sein und beispielsweise von einem Hauptsteuergerät eines Kraftfahrzeugs umfasst sein.

Es ist nicht erforderlich, die Temperaturmessvorrichtung 13 in der Nähe des zu überwachenden Schützes 19 anzuordnen. Die Temperaturmessvorrichtung 13 misst nicht direkt die Temperatur des Schützes 19, sondern lediglich eine Umgebungstemperatur, beispielsweise eine Temperatur in der Nähe der Batteriezellen.

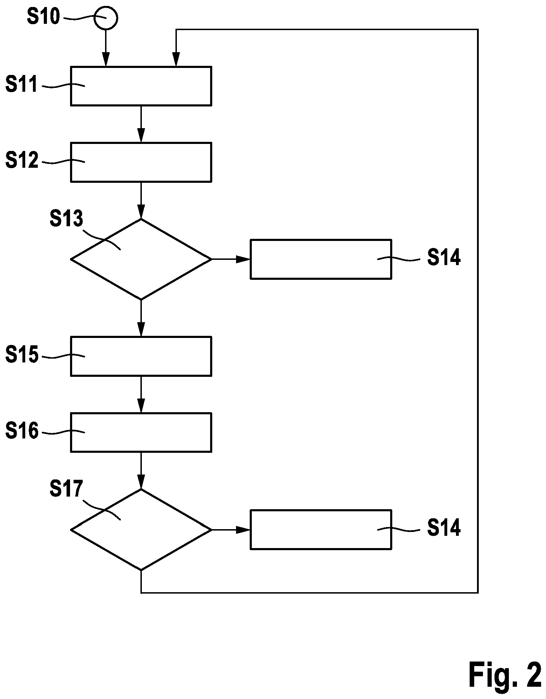

Figur 2 zeigt ein Ausführungsbeispiel des erfindungsgemäßen Verfahrens zur Vorhersage der Einsatzfähigkeit eines Schützes, welches in der in Figur 1 dargestellten Batterie 100 ausgeführt wird. Während des gesamten Prozesses erfassen die Strommessvorrichtung 11, die Spannungsvorrichtung 12 und die Temperaturmessvorrichtung 13 Messdaten und übermitteln diese an die Beobachtungseinheit 22. Ebenfalls während des gesamten Prozesses wird durch die Beobachtungseinheit 22 eine aktuelle Temperatur des Schützes 19 berechnet beziehungsweise abgeschätzt. Für den Fall, dass über eine längere Periode kein Strom durch das Schütz 19 fließt, wird die geschätzte Temperatur des Schützes 19 mit der Umgebungstemperatur gleichgesetzt.

Im Verfahrensschritt S11 befindet sich das Schütz 19 in einem geöffneten Zustand. Durch das Schütz 19 fließt kein Strom, so dass keine weitere Erwärmung des Schützes 19 erfolgen kann.

Im Verfahrensschritt S12 wird das Schütz 19 geschlossen. Während des Schaltvorgangs erfolgt ein Funkenüberschlag, welcher die Kontakte des Schützes 19 erhitzt. Der Stromimpuls während des Funkenüberschlags wird gemessen und der damit zusammenhängende Temperaturanstieg in dem Schütz 19 durch die Beobachtungseinheit 22 berechnet.

Vor allem bei wiederholtem Öffnen und Schließen des Schützes 19 innerhalb kurzer Zeit kann seine Temperatur derart steigen, dass die Kontakte auf Grund eines Schweißprozesses verkleben. Daher wird im Schritt S13 die geschätzte Temperatur des Schützes 19 mit einem vorbestimmten Temperaturschwellenwert verglichen. Wenn die geschätzte Temperatur des Schützes 19 größer als der vorbestimmte Temperaturschwellenwert ist, wird im Schritt S14 ein Warnsignal erzeugt, indem beispielsweise eine Tauschempfehlung ausgesprochen wird, durch welche eine Fehlfunktion des Schützes 19 vermieden werden kann. Die Abschätzung des Temperaturanstiegs in dem Schütz 19 wird hierbei auf Grundlage eines Temperaturmodells durchgeführt, welches einen Stromimpuls und den damit verbundenen Temperaturanstieg miteinander in Beziehung setzt.

Wenn die geschätzte Temperatur des Schützes 19 nicht größer als der vorbestimmte Temperaturschwellenwert ist, wird im Verfahrensschritt S15 der Verlauf des durch das Schütz 19 fließenden Stromes im durchgehenden Betrieb, wenn die Kontakte geschlossen sind, aufgezeichnet. Dabei erwärmt sich das Schütz 19 durch den fortlaufenden Betriebsstrom. Diese Erwärmung des Schützes 19 wird durch das von der Beobachtungseinheit 22 verwendete Modell vorhergesagt. Dabei wird auch berücksichtigt, dass die Erwärmung der Kontakte umso höher ist, desto größer die bereits vorhandene Beschädigung der Kontakte ist. Aus der Erwärmung der Kontakte, genauer aus der zeitlichen Entwicklung der geschätzten Temperatur des Schützes 19, kann die Alterung des Schützes 19 vorhergesagt werden.

Im Verfahrensschritt S16 wird das Schütz 19 wieder geöffnet, was wiederum zu einem Funkenüberschlag führt, wie im Verfahrensschritt S12. Wiederum kann für den Fall (S17), dass der Temperaturanstieg, welcher durch den erzeugten Lichtbogen verursacht wird, zu hoch ist, ein Warnsignal erzeugt werden (S14). Anderenfalls wird zum Beginn des Verfahrens im Schritt S11 zurückverzweigt, wobei dieser Schritt einem geschlossenen Zustand des Schützes 19 entspricht.

Das von der Beobachtungseinheit 22 verwendete Modell kann durch Wertetabellen verfeinert werden, welche vom Hersteller des Schützes geliefert werden und üblicherweise anzeigen, wie hoch die Lebensdauer (gemessen in der Anzahl von Schaltvorgängen) eines Relais oder eines Schützes in Abhängigkeit von einem konstanten Laststrom ist. Im Gegensatz zu diesen Angaben ist das von der Beobachtungseinheit 22 benutzte Modell jedoch dazu ausgelegt, eine Alterungsvorhersage auch bei variablen Strömen treffen zu können, und somit beispielsweise den Fall berücksichtigen zu können, dass ein erster Schaltvorgang bei einem bestimmten Laststrom und danach ein zweiter bei einem zehnmal höheren Laststrom durchgeführt wird.

Die Vorhersagen bezüglich der Alterung und des Klebens des Schützes 19 werden von der Beobachtungseinheit 22 über eine Datenverbindung, insbesondere über ein Bussystem, anderen Steuergeräten mitgeteilt, beispielsweise dem Hauptsteuergerät des Kraftfahrzeugs.

## Patentansprüche

1. Verfahren zur Vorhersage der Einsatzfähigkeit eines Relais oder eines Schützes (19), bei dem ein durch das Relais oder das Schütz (19) fließender Strom und/oder eine an dem Relais oder dem Schütz (19) anliegende Spannung wiederholt gemessen wird (11, 12) und die Messwerte an eine Beobachtungseinheit (22) übermittelt werden, **dadurch gekennzeichnet, dass** ein Messen des durch das Relais oder das Schütz (19) fließenden Stroms und/oder einer der an dem Relais oder dem Schütz (19) anliegenden Spannung während eines Schaltvorgangs des Relais oder des Schützes (19) erfolgt und dass die Beobachtungseinheit (22) auf Grundlage der Messwerte und eines einen Stromimpuls und den damit verbundenen Temperaturanstieg des Relais oder des Schützes (19) in Beziehung setzenden Temperaturmodells einen Temperaturanstieg des Relais oder des Schützes (19) berechnet oder abschätzt und anhand dessen eine Vorhersage über die Einsatzfähigkeit des Relais oder des Schützes (19) macht.

2. Verfahren nach Anspruch 1, wobei das Verfahren zur Berechnung einer Alterung (S15) oder zur Vorhersage eines Klebens (S13) des Relais oder des Schützes (19) verwendet wird.

3. Verfahren nach Anspruch 1 oder 2, wobei die Beobachtungseinheit (22) auf Grundlage der Messwerte und des Modells eine aktuelle Temperatur des Relais oder des Schützes (19) abschätzt.

4. Verfahren nach Anspruch 3, wobei eine Umgebungstemperatur des Relais oder des Schützes gemessen (13) und der Umgebungstemperaturmesswert an die Beobachtungseinheit (18) übermittelt wird.

5. Verfahren nach einem der vorangehenden Ansprüche, wobei der durch das Relais oder das Schütz fließende Strom und/oder die an dem Relais oder dem Schütz anliegende Spannung gemessen wird, während das Relais oder das Schütz geschlossen ist (S15).

6. Verfahren nach einem der vorangehenden Ansprüche, wobei ein Warnsignal erzeugt wird (S14), wenn die geschätzte Temperatur des Relais oder des Schützes einen Temperaturschwellenwert übersteigt (S13, S17).

7. Beobachtungseinheit (22), die als Teil einer Batterie (100), insbesondere einer Batteriemanagementeinheit oder als Teil eines Hauptsteuergerätes eines Kraftfahrzeuges ausgebildet und dazu ausgelegt ist, ein Verfahren nach einem der vorangehenden Ansprüche auszuführen.

8. Batterie (100) mit einem Relais oder einem Schütz (19) sowie mit einer Beobachtungseinheit (22) nach Anspruch 7.

9. Kraftfahrzeug, insbesondere elektrisches Kraftfahrzeug, mit einer Batterie (100) nach Anspruch 8.

## Claims

1. Method for predicting the usability of a relay or a contactor (19), in which method a current flowing through the relay or the contactor (19) and/or a voltage present at the relay or the contactor (19) is measured repeatedly (11, 12) and the measured values are transmitted to a monitoring unit (22), **characterized in that** a measurement of the current flowing through the relay or the contactor (19) and/or the voltage present at the relay or the contactor (19) takes place during a switching operation of the relay or the contactor (19) and **in that** the monitoring unit (22) calculates or estimates a temperature rise of the relay or of the contactor (19) on the basis of the measured values and a temperature model which draws a relationship between a current pulse and the temperature rise, associated therewith, of the relay or of the contactor (19), and, on the basis of said temperature rise, said monitoring unit makes a prediction on the usability of the relay or the contactor (19).

2. Method according to Claim 1, wherein the method is used for calculating aging (S15) or for predicting jamming (S13) of the relay or the contactor (19).

3. Method according to Claim 1 or 2, wherein the monitoring unit (22) estimates a present temperature of the relay or the contactor (19) on the basis of the measured values and the model.

4. Method according to Claim 3, wherein an ambient temperature of the relay or the contactor is measured (13) and the ambient temperature measured value is transmitted to the monitoring unit (18).

5. Method according to one of the preceding claims, wherein the current flowing through the relay or the contactor and/or the voltage present at the relay or the contactor is measured while the relay or the contactor is closed (S15).

6. Method according to one of the preceding claims, wherein a warning signal is generated (S14) when the estimated temperature of the relay or the contactor exceeds a temperature threshold value (S13, S17).

7. Monitoring unit (22), which is formed as part of a battery (100), in particular of a battery management unit, or as part of a main control device of a motor vehicle, and which is designed to implement a method according to one of the preceding claims.

8. Battery (100) with a relay or a contactor (19) and with a monitoring unit (22) according to Claim 7.

9. Motor vehicle, in particular electric motor vehicle, with a battery (100) according to Claim 8.

## Revendications

1. Procédé de prédiction de la disponibilité opérationnelle d'un relais ou d'une protection (19), dans lequel un courant passant dans le relais ou la protection (19) et/ou une tension appliquée au relais ou à la protection (19) sont mesurés de manière répétée (11, 12) et les valeurs de mesure sont transmises à une unité d'observation (22), **caractérisé en ce qu'**une mesure du courant passant dans le relais ou la protection (19) et/ou d'une des tensions appliquées au relais ou à la protection (19) est effectuée pendant un processus de commutation du relais ou de la protection (19) et **en ce que** l'unité d'observation (22) calcule ou estime une élévation de température du relais ou de la protection (19) sur la base des valeurs de mesure et d'un modèle de température mettant en relation une impulsion de courant et l'élévation de température qui lui est associée du relais ou de la protection (19) et fait une prédiction de la disponibilité opérationnelle du relais ou de la protection (19).

2. Procédé selon la revendication 1, dans lequel le procédé est utilisé pour calculer un vieillissement (S15) ou pour prédire un collage (S13) du relais ou de la protection (19).

3. Procédé selon la revendication 1 ou 2, dans lequel l'unité d'observation (22) estime une température actuelle du relais ou de la protection (19) sur la base des valeurs de mesure et du modèle.

4. Procédé selon la revendication 3, dans lequel une température ambiante du relais ou de la protection est mesurée (13) et la valeur de température ambiante est transmise à l'unité d'observation (18).

5. Procédé selon l'une des revendications précédentes, dans lequel le courant passant dans le relais ou la protection et/ou la tension appliquée au relais ou à la protection sont mesurés alors que le relais ou la protection est fermé (S15).

6. Procédé selon l'une des revendications précédentes, dans lequel un signal d'alarme est généré (S14) lorsque la température estimée du relais ou de la protection dépasse une valeur de seuil de température (S13, S17).

7. Unité d'observation (22) réalisée en tant que partie d'une batterie (100), en particulier d'une unité de gestion de batterie ou en tant que partie d'un appareil de commande principal d'un véhicule automobile et conçue pour mettre en oeuvre un procédé selon l'une des revendications précédentes.

8. Batterie (100) comportant un relais ou une protection (19) et une unité d'observation (22) selon la revendication 7.

9. Véhicule automobile, en particulier un véhicule automobile électrique, comportant une batterie (100) selon la revendication 8.
